# EUROPÄISCHE PATENTSCHRIFT

(11) **EP 2 807 676 B1**
(45) Veröffentlichungstag und Bekanntmachung des Hinweises auf die Patenterteilung: **16.10.2019**
(21) Anmeldenummer: 13701609.3
(22) Anmeldetag: 22.01.2013
(51) Int. Cl.: H01L 31/0224, H01L 31/05

(54) **VERFAHREN ZUM HERSTELLEN EINES ELEKTRISCH LEITENDEN KONTAKTS AUF EINER SOLARZELLE**
METHOD FOR PRODUCING AN ELECTRICALLY CONDUCTIVE CONTACT ON A SOLAR CELL
PROCÉDÉ DE FABRICATION D'UN CONTACT ÉLECTROCONDUCTEUR SUR UNE PHOTOPILE

(30) Priorität: 23.01.2012 DE 102012100535
(43) Veröffentlichungstag der Anmeldung: 03.12.2014
(73) Patentinhaber: Fraunhofer-Gesellschaft zur Förderung der angewandten Forschung e.V., 80686 München (DE)
(72) Erfinder: MARTINI, Marcel, 63457 Hanau (DE); HUBER, Stephan, 83562 Rechtmehring (DE); MEYER, Stefan, 63549 Ronnenburg (DE); VON CAMPE, Hilmer, 61352 Bad Homburg (DE); BÖHME, Sven, 09600 Niederschöna (DE)
(86) Internationale Anmeldenummer: PCT/EP2013/051143
(87) Internationale Veröffentlichungsnummer: WO 2013/110607

(56) Entgegenhaltungen:
- EP-A2- 2 003 699
- DE-A1-102009 044 038
- DE-A1-102010 000 520
- DE-B3-102010 016 814
- JP-A- H10 313 126
- US-A1- 2008 076 307
- US-A1- 2011 048 492
- US-A1- 2011 120 752

## Beschreibung

Die Erfindung bezieht sich auf ein Verfahren zum Herstellen eines elektrisch leitenden Kontakts auf einer Rück- und/oder Vorderseite einer Solarzelle, wobei der Kontakt mit einem Solarzellen verschaltenden Verbinder mittels eines Klebemittels verbunden wird.

Es ist bekannt, unter Beibehaltung des Aufbaus einer Solarzelle deren Busbars über einen elektrisch leitfähigen Klebstoff mit einem Zellenverbinder elektrisch leitend zu verbinden (s. INTERSOLAR 2011, 31. Mai 2011).

Um Halbleiterbauelemente elektrisch leitend zu verbinden, wird nach der JP-A-03188180 ein elektrisch leitfähiges Material enthaltendes Epoxidharz, Phenolharz oder Phenoxyharz benutzt.

Um einen Halbleiterchip mit Elektroden zu verbinden, ist es nach der JP-A-03183527 bekannt, zwischen Kontakten einen leitfähigen Film anzuordnen, der durch Einwirkung von Ultraschall zeitweise aufgeschmolzen wird.

Zum elektrisch leitenden Verbinden von z. B. LCDs wird nach der JP-A-06045024 ein elektrisch leitender Kleber benutzt.

Die US 2008/0076307 A1 bezieht sich auf eine Verbindung zwischen einem Verbinder und einer Solarzelle. Der Verbinder besteht aus einem Leiter und einer diesen umgebenden z. B. galvanisch aufgetragenen Schicht. Der Verbinder kann mit einem leitenden Kleber oder Lotmaterial in dem Bereich versehen werden, in dem der Kontakt zur Solarzelle hergestellt wird. Auch besteht die Möglichkeit, auf den Bereich der Solarzelle einen Kleber oder ein Lotmaterial aufzubringen, in der der Kontakt mit dem Verbinder hergestellt werden soll.

Ein Verschalten von Solarzellen zu einem Solarzellenmodul ist der EP 2 056 355 A1 zu entnehmen. Hierzu wird zunächst auf die Solarzelle ein Busbar aufgebracht, der sodann von einer Kleberschicht abgedeckt wird. Anschließend wird unter Druckbeaufschlagung ein Verbinder bei gleichzeitiger Wärmeeinwirkung aufgebracht, so dass der Verbinder teilweise den Busbar umgibt.

Ein Verbindungsverfahren für Halbleiterchips wird in der US 7 264 991 B1 beschrieben. Zwischen dem Halbleiterchip und dem Verbinder ist ein elektrisch leitender Kleber vorgesehen, um eine Sandwich-Struktur zu bilden. Außerhalb der Verbindung wird der Kleber z. B. mittels Bürstens entfernt.

Nach der US 2011/0048492 A1 werden Solarzellen über Verbinder elektrisch leitend verbunden, die über einen elektrisch leitende Parikel enthaltenden Klebstoff mit den Solarzellen kontaktiert werden.

Aus der US 2011/0120752 A1 ist ein Solarzellenmodul bekannt. Auf die einzelnen Solarzellen wird ein elektrisch leitendes Klebematerial gedruckt, um eine Verschaltung zu ermöglichen.

Die DE 10 2010 016 814 B3 bezieht sich auf ein Verfahren zum Aufbringen von Lot auf eine Solarzelle.

Ein umfangsseitig plattierter Verbinder ist aus der US 2008/0076307 A1 bekannt.

Um auf einer porösen Rückseite einer Solarzelle einen Verbinder zu befestigen, ist nach der EP 2 003 699 A2 vorgesehen, dass ein lötbares Material einlegiert wird.

JP H10 313126 A offenbart ein Verfahren zum Herstellen eines elektrisch leitenden Kontakts einer Solarzelle, wobei der Kontakt mit einem Verbinder mittels eines Klebemittels verbunden wird. Im Bereich des auszubildenden Kontakts wird zunächst mittels Ozon oxidiert. Danach wird ein Klebstoff in dem Kontaktbereich aufgebracht.

Zum Aufbringen von Lotmaterial auf eine Solarzelle wird nach der DE 10 2010 000 520 A1 vorgeschlagen, dass die Solarzelle während des Auftragens federnd gelagert wird.

Um einen Kontaktbereich bei einer Solarzelle nach der DE 10 2009 044 038 A1 auszubilden, wird ersterer verdichtet.

Der vorliegenden Erfindung liegt die Aufgabe zu Grunde, kostengünstig Solarzellen zu verschalten, wobei gleichzeitig sichergestellt sein soll, dass Zellschädigungen, die zu einer Leistungsdegradation führen, vermieden werden. Insbesondere soll vermieden werden, dass Schädigungen der Klebeverbindungen wie z. B. Delaminationen auftreten. Es soll eine sichere Verbindung hergestellt werden.

Zur Lösung der Aufgabe wird erfindungsgemäß im Wesentlichen vorgeschlagen, dass die Oberfläche der Rück- und/oder Vorderseite der Solarzelle im Bereich des auszubildenden Kontakts behandelt wird durch zumindest eine Maßnahme aus der Gruppe zumindest partielles Verdichten, Auftragen von Lotmaterial mittels Ultraschall und dass nach dem Behandeln in dem bzw. auf den Bereich streifenförmig ein pastenförmiger Klebstoff oder ein Klebstoffband als das Klebemittel bei gleichzeitig elektrisch leitender Verbindung in bzw. mit dem Bereich aufgebracht wird.

Um erfindungsgemäß eine sichere Verbindung zwischen dem Klebemittel in Form des streifenförmig aufgetragenen pastenförmigen Klebstoffs oder des Klebebands und der Rück- und/oder Vorderseite der Solarzelle sicherzustellen, wird diese vorbehandelt bzw. behandelt. Vorbehandelt bzw. behandelt bedeutet dabei, dass ein Verdichten bzw. Verfestigen zumindest in dem Bereich, vorzugweise im Wesentlichen nur in dem Bereich erfolgt, in dem das Klebemittel aufgetragen wird. Der Begriff Oberfläche schließt dabei auch den oberflächennahen Bereich ein. Vorbehandeln bedeutet folglich nicht das übliche Reinigen oder Säubern der Kontaktflächen, bevor das Klebemittel aufgetragen wird.

Durch das Behandeln der Oberfläche in den gewünschten Bereichen wird gewährleistet, dass das Klebemittel mit der erforderlichen Haftung auf der Rück- und/oder Vorderseite der Solarzelle verbunden ist, so dass Abzugskräfte auf das Klebemittel einwirken können, die ansonsten nur dann erreichbar sind, wenn das Klebemittel - wie nach dem Stand der Technik - mit insbesondere aus Silber bestehenden Busbars oder Pads verbunden wird. Da aufgrund der erfindungsgemäßen Lehre entsprechende Busbars und Pads für das Klebemittel nicht erforderlich sind, ergibt sich eine Kosteneinsparung. Zum elektrisch leitenden Verbinden mit den Zellverbindern ist des Weiteren aufgrund des verwendeten Klebemittels ein Löten grundsätzlich nicht erforderlich, so dass Zellschädigungen aufgrund der ansonsten auftretenden Temperaturen und eine damit einhergehende Leistungsdegradation vermieden werden.

Als Material für das Klebemittel wird insbesondere zumindest ein Material aus der Gruppe Phenolharz, Epoxidharz, Phenoxyharz, Polyurethan, Silikon, Acrylat verwendet, das vorzugsweise elektrisch leitende Partikel enthält. Die Erfindung wird jedoch auch dann nicht verlassen, wenn beim Auftragen des Klebemittels dieses elektrisch leitende Partikel nicht enthält, diese vielmehr erst nach dem Auftragen auf die Rück- und/oder Vorderseite der Solarzelle in diese gelangen. Dies erfolgt dann, wenn zumindest ein Kontakt, z. B. der Rückkontakt, aus einer ziemlich porösen Schicht, wie Aluminiumschicht, besteht, und der Kleber zur Verfestigung des porösen Materials in die Schichtstruktur eingetrieben wird. Hierbei bleibt die elektrische Leitfähigkeit der Kontaktschicht erhalten, während die Festigkeit wächst.

Zum Behandeln des Bereichs, in dem der Kontakt hergestellt werden soll, erfolgt zumindest eine Maßnahme aus der Gruppe zumindest partielles Verdichten in einem gewünschten Oberflächenbereich, Auftragen von Lotmaterial mittels Ultraschall auf den gewünschten Oberflächenbereich. Durch diese Maßnahmen dringt das Lotmaterial in die Oberfläche ein und es erfolgt ein Verdichten. Ein Verdichten kann z.B. auch mechanisch erreicht werden.

Es besteht auch die Möglichkeit des Auftragens eines Polymers mit endständigen funktionalen Gruppen. Beispielhaft ist das Auftragen eines Silans und Thiol mit endständigen funktionalen Gruppen wie Amino- oder Epoxidgruppen zu nennen.

Das zumindest partielle Verdichten kann mittels Ultraschallbeaufschlagung, Laserbestrahlung, Wärmebehandlung und/oder mechanischer Oberflächenbehandlung durchgeführt werden. Letzteres ist z. B. mittels einer Bürste möglich, wodurch quasi ein Verschmieren/Glätten der Oberfläche, insbesondere bei einer kristallinen Solarzelle mit poröser Rückseite aus sehr duktilem Material erfolgt, so dass die Haftung zu dem Klebemittel verbessert wird. Insbesondere ist auch vorgesehen, dass in die Oberfläche der Rückseite ein lötbares oder metallisch benetzbares Material einlegiert wird, insbesondere zumindest ein Material aus der Gruppe Sn, Pb, In, Ga, Cd, Fe, Ag, Au, Ti, Hf, Zn, Mg, Ca, Ba, Lotmaterial oder eine Mischung von Materialien der Gruppe.

Die zur Herstellung des Kontaktes behandelten Bereiche können pad- oder streifenförmig ausgebildet werden, ohne dass es sich hierbei um Busbars oder Pads handelt, die nach dem Stand der Technik zum Verbinden mit Zellenverbindern benutzt werden und insbesondere aus Silber bestehen. Vielmehr werden die pad- oder streifenförmigen Bereiche durch Behandeln der Rück- bzw. Vorderseite der Solarzelle ausgebildet, wobei insbesondere ein Verdichten des Oberflächenbereichs mittels Ultraschall oder Laserbestrahlung zu bevorzugen ist. Bezüglich des Verlaufs des streifenförmigen Bereichs ist anzumerken, dass dieser parallel oder senkrecht zu den Fingern verlaufen kann. Der die Solarzellen verbindende Verbinder verläuft senkrecht zu den Fingern.

Zwar ist ein Verdichten insbesondere eines Rückseitenbereichs durch Einlegieren von Lotmaterial bekannt (EP-A-2 003 699). Auf die entsprechenden verdichtenden Bereiche erfolgt jedoch sodann durch Löten ein stoffschlüssiges Verbinden mit einem Zellenverbinder, wodurch aufgrund der auftretenden Temperaturen eine Zellschädigung erfolgen kann.

Ein Verdichten mittels Ultraschall ist auch aus der DE-B-10 2010 016 814 oder der DE-A-10 2010 000 520 bekannt. Dabei wird Lotmaterial auf Temperaturen bis 500 °C erwärmt, so dass grundsätzlich nicht auszuschließen ist, dass eine Zellschädigung auftritt.

Aufgrund der erfindungsgemäßen Lehre erfolgt ein Einsparen von ansonsten erforderlichem Silber zum elektrisch leitenden Verbinden zwischen Zellenverbindern und einer Solarzelle. Als Zellenverbinder können kostengünstige verzinnte oder verzinkte Kupferbänder oder Aluminiumbänder benutzt werden, wobei sich Produktionskosten einsparen lassen. Daher zeichnet sich die Erfindung auch dadurch aus, dass die Möglichkeit besteht, ohne Verwendung von Silber, also silberfrei eine elektrische Verbindung zwischen einer Solarzelle und einem Zellenverbinder auszubilden.

Ein Vorbehandeln der Bereiche, in denen Zellenverbinder mit einer Solarzelle verbunden werden sollen, schließt auch ein, dass zur Erzielung einer weitgehend ebenen Haftfläche zuvor ein weiteres Klebstoffmaterial aufgetragen wird, das frontseitig die Texturierung, rückseitig bei einer porösen Rückseitenfläche wie Aluminiumfläche die Poren verschließt und somit eine gewünschte ebene Kontaktfläche als den Bereich zur Verfügung stellt. Im eigentlichen Sinne erfolgt durch das Klebstoffmaterial auch ein Verdichten, insbesondere dadurch, dass das Material in den Rückkontakt eingetrieben wird, wodurch an dieser Stelle eine Verfestigung des Materials eintritt.

Die Erfindung zeichnet sich daher auch dadurch aus, dass die Oberfläche in dem Bereich, in dem der elektrische leitende Kontakt hergestellt werden soll, mittels eines Klebstoffmaterials geglättet wird, und dass auf das Klebstoffmaterial sodann das Klebemittel aufgetragen wird, mit dem anschließend der Verbinder verbunden wird. Ein Glätten kann jedoch auch durch ein Lotmaterial durchgeführt werden.

Insbesondere kann frontseitig die Texturierung durch ein Lotmaterial "geebnet" bzw. geglättet werden, um zu vermeiden, dass das Klebermaterial bzw. Klebemittel im Wesentlichen auf den Scheitelbereichen der texturierten Oberfläche anhaftet.

Rückseitig kann die Oberflächenbehandlung insbesondere durch lokale oder vollflächige Laserbestrahlung oder durch Ultraschalleinwirkung erfolgen, wie dies aus der DE-A-10 2009 044 038 bekannt ist. Die Einlegierungsmaßnahmen nach der EP-A-2 003 699 können auf der Rückseite gleichfalls zur Anwendung gelangen, wobei sodann unmittelbar das Klebemittel aufgebracht wird.

Bei der Ultraschallbeaufschlagung kann zusätzlich eine Verzinnung durchgeführt werden.

Die erfindungsgemäße Lehre ist auf einen bestimmten Solarzellentyp nicht beschränkt. Bevorzugterweise werden jedoch kristalline Solarzellen wie kristalline Siliziumsolarzellen oder Dünnschichtsolarzellen verwendet.

Als das Klebeband und/oder streifenförmig aufgebrachter Klebstoff wird insbesondere ein solches bzw. ein solcher mit einer Breite B mit 0,5 mm ≤B ≤10 mm, insbesondere 0,8 mm ≤B ≤2 mm, und/oder einer Dicke D mit 3 µm ≤D ≤50 µm verwendet. Die aktuelle Breite des Klebebandes richtet sich nach der Breite der Verbinder.

Unter Klebstoff ist auch ein Lack, insbesondere Klarlack zu subsumieren. Hierdurch ergibt sich der Vorteil, dass die Breitenerstreckung größer als die des Zellenverbinders sein kann, ohne dass eine unerwünschte Abschattung im Frontseitenbereich erfolgt.

Als bevorzugte Klebstoffe als das Klebemittel sind Epoxidharz, Phenolharz, Phenoxyharz, Polyurethan, Silikon, UV-härtendes Acrylat zu nennen. Damit der Klebstoff leitend wird, können als Füllstoffe ein Material oder mehrere Materialen aus der Gruppe Silber, Kupfer, Aluminium, Gold, Graphit, Zink, Zinn, Palladium gewählt werden.

Wird eine Paste als Klebemittel benutzt, so gelangen vorzugsweise folgende Verfahrensschritte zur Anwendung. Nach der Oberflächenbehandlung der Kontaktfläche der Zelle, also den Bereichen, in dem der Verbinder mit der Solarzelle elektrisch leitend verbunden werden soll, wird die Paste aufgetragen. Anschließend wird der Verbinder mit leichtem Andrücken zum flächigen Verteilen der Paste aufgelegt. Schließlich erfolgt ein Antrocknen bzw. Aushärten der Paste, wobei dieses durch Erhöhen der Temperatur beschleunigt werden kann. Das Aushärten sollte im Bereich zwischen Raumtemperatur und 300 °C, bevorzugt im Bereich zwischen 100 °C und 200 °C erfolgen. Die Temperatur sollte über einen Zeitraum zwischen 0,5 sek und 25 min einwirken. Es besteht jedoch auch die Möglichkeit, das Aushärten erst in einem Laminator durchzuführen, in dem ein Solarzellenmodul hergestellt wird.

Wird ein Klebeband als Klebemittel verwendet, so sind nachstehende Maßnahmen bevorzugt anzuwenden. Nach der Oberflächenbehandlung der Kontaktfläche der Zelle, also des Bereichs, in dem der Verbinder kontaktiert werden soll, wird das Klebeband aufgebracht. Anschließend wird der Verbinder mit etwas Druck und bei einer Wärme zwischen Raumtemperatur und vorzugsweise 70 °C aufgelegt. Es können Maßnahmen erfolgen, wie dies bei Standard-Stringern der Fall ist. Das Bonden bzw. Aushärten des Klebstoffs sollte bei einem Druck zwischen 0,5 MPa und 4 MPa bei einer Temperatur zwischen 100 °C und 200 °C in einem Zeitraum zwischen 0,5 s und 30 s erfolgen.

Ganz allgemein ist anzumerken, dass das Aushärten bzw. Bonden, also die Verbindung zwischen dem Verbinder und dem Klebemittel, auch mittels Ultraschall möglich ist.

Weitere Einzelheiten, Vorteile und Merkmale der Erfindung ergeben sich nicht nur aus den Ansprüchen, den diesen zu entnehmenden Merkmalen - für sich und/oder in Kombination-, sondern auch aus der nachfolgenden Beschreibung von der Zeichnung zu entnehmende bevorzugten Ausführungsbeispielen.

Es zeigen:
- Fig. 1: eine Draufsicht auf eine Solarzelle,
- Fig. 2: eine Ansicht der Solarzelle gemäß Fig. 1 von der Rückseite her,

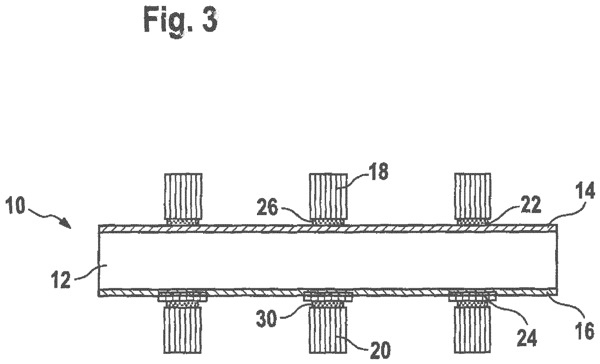

- Fig. 3: einen Querschnitt durch die Solarzelle der Fig. 1 und 2.,
- Fig. 4: eine weitere Prinzipdarstellung einer Solarzelle,
- Fig. 5: eine Prozessfolge zur Herstellung einer elektrisch leitenden Verbindung zwischen einer Rückseite einer Solarzelle und einem Verbinder und
- Fig. 6, 7: Solarzellen mit entlang deren Rückseiten verlaufenden Verbindern.

Den Figuren ist rein prinzipiell eine kristalline Siliziumsolarzelle 10 zu entnehmen, die z. B. aus einem p-leitenden Substrat 12 mit pn-Übergang besteht und eine Frontseitenmetallisierung 14 als Frontkontakt und einen Rückseitenkontakt 16 aufweist, der insbesondere als vollflächig gesinterte Aluminiumschicht mit einer Porosität zwischen 5 % und 20 % ausgebildet ist, um über die gesamte Rückseite ein Back-Surface-Field auszubilden. Um die Solarzelle 10 mit weiteren Solarzellen zu verschalten, muss die Rückseite, also der Rückseitenkontakt 16 und die Frontseite, also der Frontseitenkontakt 14 mit sogenannten Zellen verhindern 18, 20 elektrisch leitend verbunden werden, die aneinander grenzende Zellen miteinander verbinden. Dabei erstreckt sich der frontseitig verlaufende Zellenverbinder 18 der Solarzelle 10 zur Rückseite z. B. einer nachfolgenden Solarzelle und umgekehrt der rückseitig verlaufende Zellenverbinder 20 zur Frontseite einer vorgeordneten Solarzelle und umgekehrt.

Damit die Zellenverbinder 18, 20 sowohl mit dem Frontseitenkontakt 14 als auch mit dem Rückseitenkontakt 16 im erforderlichen Umfang und mit der erforderlichen Festigkeit verbunden werden können, ist erfindungsgemäß vorgesehen, dass in den herzustellenden Kontaktbereichen 22, 24 der Frontseitenkontakt 14 und/oder der Rückseitenkontakt 16 behandelt wird. Dies kann insbesondere frontseitig dadurch erfolgen, dass streifenförmige Lotstreifen auf der Frontseite in den Bereichen aufgebracht werden, in denen die Zellenverbinder 18, 20 kontaktiert werden sollen. Auf die Lotstreifen werden sodann elektrisch leitende Klebestreifen 26 aufgetragen, mit denen anschließend Zellenverbinder 18 durch Kleben verbunden werden.

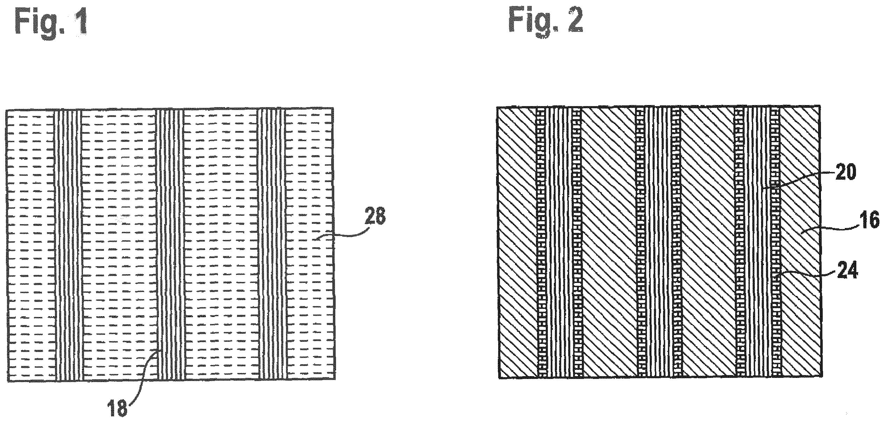

Wie sich aus der Fig. 1 ergibt, verlaufen die Zellenverbinder 18 quer zu Kontaktfingern 28, die gestrichelt dargestellt sind, gleichwenn diese durchgängig von Rand zu Rand verlaufen. Im Ausfuhrungsbeispiel erstrecken sich über die Kontaktfinger 28 insgesamt drei Zellenverbinder 18. Die Funktion der Kontaktschicht zu den Zellenverbindern 18, also der Busbars übernimmt dabei der Klebestreifen 26 bzw. das zuvor aufgebrachte Lotmaterial. Ein zusätzlicher Busbar, wie dieser nach dem Stand der Technik notwendig ist und grundsätzlich aus Silber besteht, entfällt somit.

Rückseitig wird in den Bereichen, in denen die Zellenverbinder 20 verlaufen, die insbesondere aus Aluminium bestehende Rückseitenschicht 16 verdichtet. Dies kann durch reines mechanisches Behandeln z. B. mittels einer Bürste erfolgen, wodurch die poröse Oberfläche geglättet und somit eine hinreichende Haftfläche für den Klebestreifen 30 gebildet wird.

Insbesondere erfolgt jedoch eine Laserbestrahlung oder eine Ultraschallbeaufschlagung, wobei zusätzlich ein Einlegieren von Material wie Lotmaterial erfolgen kann, wie dies z. B. in der EP-A-2 003 699 beschrieben ist.

Ein Verdichten kann z. B. durch Laserbestrahlung erfolgen, wie dies die DE-A-10 2009 044 038 lehrt. Insoweit wird auf die diesbezüglichen Offenbarungen ausdrücklich Bezug genommen.

Auf die entsprechend behandelten streifenförmigen Bereiche 24 wird sodann jeweils ein Klebestreifen 30 aufgetragen, der die Verbindung zwischen dem Bereich 24 und dem Zellenverbinder 20 herstellt.

Nachstehend wird die erfindungsgemäße Lehre anhand von bevorzugten Ausführungsbeispielen näher erläutert.

Anhand der nachstehend beschriebenen Ausführungsbeispiele ergeben sich weitere hervorzuhebende Merkmale der erfindungsgemäßen Lehre.

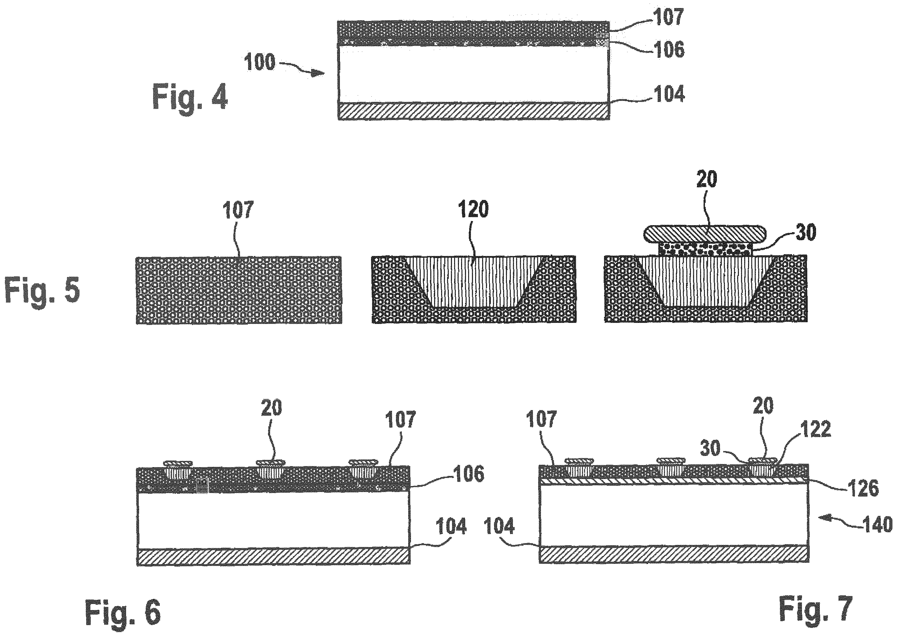

In Fig. 4 ist eine weitere Prinzipdarstellung einer kristallinen Siliziumsolarzelle 100 mit pn-Übergang 104 dargestellt. Die Siliziumsolarzelle 100 wird rückseitig ganzflächig mit einer Paste aus Aluminium bedruckt. Zur Kontaktbildung der so gebildeten Aluminiumschicht 107 mit dem Substrat der Solarzelle 100 wird die Aluminiumschicht 107, die eine Dicke zwischen 30 µm und 50 µm aufweisen kann, gesintert. Bei diesem Prozess entsteht in direkter Nachbarschaft zur Rückseite des Substrats der Solarzelle 100 eine eutektische Verbindung Al-Si, die in der Fig. 4 mit 106 gekennzeichnet ist. Die Dicke beläuft sich auf ca. 5 µm. Der verbleibende Bereich der Aluminiumschicht 107 weist somit eine Dicke zwischen 25 µm und 45 µm auf, je nachdem wie die Ursprungsdicke der Aluminiumschicht 107 ausgelegt war. Die verbleibende Schicht besteht aus einem locker gesinterten Verbund aus Aluminiumkugeln und Glasfrittenanteilen, dessen Festigkeit nicht besonders hoch ist. Befestigt man auf die Schicht 107 einen Verbinder, so erreicht man nur begrenzte Abzugskräfte - insbesondere ≤1 N -, da die Abzugskraft von der Festigkeit der Unterlage bestimmt wird.

Nach einem erfindungsgemäßen Aspekt wird die Schicht 107 durch eine Ultraschallbelotung mittels eines Lotes verfestigt, also behandelt. Dies geschieht dadurch, dass das Lot in die Poren der locker gesinterten Aluminiumschicht 107 eindringt und ein Bereich 120 (Fig. 5) entsteht, der im Vergleich zu der Schicht 107 außerhalb des beloteten Bereichs verdichtet ist und somit eine höhere Festigkeit aufweist. Bei einer Belotungstemperatur um 250 °C beträgt die Eindringtiefe des Lotmaterials zwischen 10 µm bis 30 µm. Allerdings ist anzumerken, dass die Eindringtiefe von der vorgegebenen Porosität und Konsistenz der Aluminiumpaste abhängt. Mit zunehmender Belotungstemperatur erhöht sich die Eindringtiefe des Lots. Dabei ist festzustellen, dass bei einer Temperatur zwischen 350 °C und 400 °C die gesamte Schicht 107 bis zum Eutektikum 106 durchdrungen wird. Durch die hierdurch entstehende Verfestigung des Materials sind höhere Abzugskräfte erzielbar. Auf den entsprechenden verfestigten Bereich 120 wird sodann entsprechend der Prinzipdarstellung der Fig. 5 das Klebemittel in Form des Klebestreifens 30 aufgebracht, um sodann in vorbeschriebener Weise auf diesen den Verbinder 20 aufzulegen und über den Klebestreifen 30 elektrisch leitend mit dem Bereich 120 und damit dem Rückkontakt 107 der Solarzelle 100 zu verbinden.

In der Fig. 6 ist die Solarzelle 100 mit den verdichteten Bereichen 120 und den Verbindern 20 prinzipiell dargestellt. Man erkennt, dass das Lotmaterial beabstandet zum Eutektikum 106 verläuft. Selbstverständlich besteht entsprechend der zuvor erfolgten Erläuterungen auch die Möglichkeit, dass der verdichtete Bereich 120 sich bis zum Eutektikum 106 erstreckt.

Alternativ besteht die Möglichkeit anstelle von Lot einen flüssigen Kleber zu infiltrieren, um den Bereich zu behandeln, der mit einem Zellenverbinder elektrisch leitend verbunden werden soll. Dies kann je nach Art des Klebers bei verschiedenen Temperaturen geschehen. Es ist z.B. möglich bei Raumtemperatur bzw. 20 °C bis ca. 80 °C einen flüssigen Kleber zu infiltrieren, der durch Ausdampfen von Lösungsmittel aushärtet. Andere Kleber (z. B. Thermoplast) werden erst bei höheren Temperaturen flüssig. Wird in die poröse Aluminiumschicht 107 einer Solarzelle 140 ein entsprechender Kleber infiltriert, so wird in dem infiltrierten Bereich nach dem Aushärten eine Stabilisierung der Festigkeit des entsprechenden Bereichs 122 der Aluminiumschicht 107 erzielt. Das Aushärten erfolgt beispielsweise durch Ausdampfen des Lösungsmittels, Abkühlen bei Thermoplasten, Vernetzung bei Mehrkomponentenklebern, UV-Härtung bei UV-härtenden Klebern. Nach dem Aushärten bildet der Kleber zusammen mit der porösen Metallschicht 107 einen festen Verbund, auf dem höhere Abzugskräfte als außerhalb des Verbundes erreicht werden. Auf die entsprechenden Bereiche 122 wird sodann in vorbeschriebener Art ein Klebemittel wie Klebestreifen 30 und auf diesen sodann ein Verbinder 20 aufgebracht (Fig. 7).

Anhand der Fig. 7 soll eine weitere Ausgestaltung der erfindungsgemäßen Lehre erläutert werden. Die Solarzelle 140 weist einen prinzipiellen Aufbau wie die Solarzelle 100 mit der Einschränkung auf, dass diese rückseitig durch eine SiN - oder eine Al2O3-Schicht 126 passiviert ist. Die entsprechende Schicht 126 ist in zuvor beschriebener Weise mit dem siebgedruckten und gesinterten Aluminiumrückkontakt 107 beschichtet. Folglich besteht der Rückkontakt im überwiegenden Bereich nur aus dem Verbund aus Aluminiumkugeln und Glasfrittenanteilen mit geringer Festigkeit. Um Bereiche höherer Festigkeit zu erzielen, erfolgt das zuvor beschriebene Infiltrieren mit einem Kleber. Alternativ könnte ein Beloten durchgeführt werden. Somit sind Bereiche 122 ausgebildet, die im Vergleich zu der verbleibenden Aluminiumschicht 107 eine höhere Festigkeit aufweisen.

Ferner kann vorgesehen sein, dass durch mechanisches Bürsten der Oberfläche des Rückkontakts die metallische Oberfläche geglättet wird, in dem die oberflächig liegenden Al-Kugeln, die sehr duktil sind, durch die mechanische Verformung flachgezogen und miteinander verbunden werden. Dies führt zu einer Verbesserung des Kontaktwiderstands zum aufzubringenden elektrisch leitenden Klebestreifen 30 bzw. dem aufzubringenden Zellen- bzw. Serienverbinder 20.

Ist das mechanische Verdichten, das z. B. durch das zuvor beschriebene Bürsten erfolgt, zusätzlich zu dem bereichsweisen Verdichten der Aluminiumschicht 107 durch Infiltrieren oder Beloten möglich, so kann auch ohne entsprechende Verfahrensschritte allein durch mechanische Bearbeitung der Rückseitenfläche der Aluminiumschicht 107 in einem Umfang eine Verfestigung bzw. eine Verbesserung des Kontaktwiderstandes erfolgen, dass eine hinreichend elektrisch leitende Verbindung zwischen dem Verbinder und der Oberfläche der Aluminiumschicht 107 über das Klebemittel wie Paste oder Klebestreifen bei gleichzeitig gewünschten relativ hohen Abzugskräften erfolgt.

In der Fig. 7 ist nicht dargestellt, dass die Schicht mehrere Öffnungen aufweisen muss, damit der elektrisch leitende Kontakt zwischen der Aluminiumschicht 107 und dem Substrat 12 der Solarzelle 10, 100, 140 hergestellt wird.

## Patentansprüche

1. Verfahren zum Herstellen eines elektrisch leitenden Kontakts auf einer Rück- und/oder Vorderseite (14, 16) einer Solarzelle (10, 100, 140), wobei der Kontakt mit einem Solarzellen verschaltenden Verbinder (18, 20) mittels eines Klebemittels (30, 26) verbunden wird,
**dadurch gekennzeichnet,**
**dass** die Oberfläche der Rück- und/oder Vorderseite (14, 16) der Solarzelle (10, 100, 140) im Bereich des auszubildenden Kontakts behandelt wird durch zumindest eine Maßnahme aus der Gruppe zumindest partielles Verdichten, Auftragen von Lotmaterial mittels Ultraschall, und dass nach dem Behandeln in dem Bereich streifenförmig ein pastenförmiger Klebstoff oder ein Klebstoffband (30, 26) als das Klebemittel bei gleichzeitig elektrisch leitender Verbindung in dem Bereich aufgebracht wird.

2. Verfahren nach Anspruch 1,
**dadurch gekennzeichnet,**
**dass** als Material für das Klebemittel ein solches auf der Basis von zumindest einem Material aus der Gruppe Epoxidharz, Phenolharz, Phenoxyharz, Polyurethan, Silikon, UV-härtendes Acrylat verwendet wird, das insbesondere elektrisch leitend ist.

3. Verfahren nach zumindest Anspruch 1,
**dadurch gekennzeichnet,**
**dass** mittels Ultraschallbeaufschlagen, Laserbestrahlung, Wärmebehandlung und/oder mechanisches Oberflächenbehandeln das zumindest partielle Verdichten der Oberfläche bzw. eines oberflächennahen Bereichs durchgeführt wird.

4. Verfahren nach Anspruch 3,
**dadurch gekennzeichnet,**
**dass** die mechanische Oberflächenbehandlung mittels Bürstens durchgeführt wird.

5. Verfahren nach zumindest einem der vorhergehenden Ansprüche,
**dadurch gekennzeichnet,**
**dass** in die Oberfläche der Rückseite (16) der Solarzelle ein lötbares oder metallisch benetzbares Material einlegiert wird, insbesondere zumindest ein Material aus der Gruppe Sn, Pb, In, Ga, Cd, Fe, Ag, Au, Ti, Hf, Zn, Mg, Ca, Ba, Lotmaterial oder eine Mischung von Materialien der Gruppe.

6. Verfahren nach zumindest einem der vorhergehenden Ansprüche,
**dadurch gekennzeichnet,**
**dass** als Solarzelle eine Solarzelle (10, 100, 140) verwendet wird, die rückseitig vollflächig eine poröse Schicht (102) als Rückkontakt aufweist, in der pad- oder streifenförmige Bereiche als die Bereiche ausgebildet werden, mit denen das Klebemittel verbunden wird.

7. Verfahren nach zumindest einem der vorhergehenden Ansprüche,
**dadurch gekennzeichnet,**
**dass** als Solarzelle eine Solarzelle (10, 100, 140) mit busbar-freier Vorderseite mit in etwa parallel zueinander verlaufenden Stromsammlern (Fingern) (28) verwendet wird, mit denen der streifenförmig aufgebrachte Klebstoff bzw. das Klebstoffband (30, 26) verbunden wird, der bzw. das quer zu den Stromsammlem verläuft.

8. Verfahren nach zumindest einem der vorhergehenden Ansprüche,
**dadurch gekennzeichnet,**
**dass** als Solarzelle (10, 100, 140) eine kristalline Solarzelle, insbesondere kristalline Silizium-Solarzelle, oder eine Dünnschicht-Solarzelle verwendet wird.

9. Verfahren nach zumindest einem der vorhergehenden Ansprüche,
**dadurch gekennzeichnet,**
**dass** mit dem Klebemittel (30, 26) ein Verbinder elektrisch leitend verbunden wird, der insbesondere aus belotetem Kupfer, verzinktem Kupfer oder aus Aluminium oder belotetem Aluminium besteht.

10. Verfahren nach zumindest einem der vorhergehenden Ansprüche,
**dadurch gekennzeichnet,**
**dass** das Klebemittel mit einer Breite B mit B 0,5 mm ≤B ≤10 mm, insbesondere 0,8 mm ≤B ≤2 mm, und/oder einer Dicke D mit 3 µm ≤D ≤50 µm auf den Bereich aufgebracht wird.

11. Verfahren nach zumindest einem der vorhergehenden Ansprüche,
**dadurch gekennzeichnet,**
**dass** der mit dem Klebemittel zu belegende Bereich zuvor mit einem funktionalen Silan aus der Gruppe Ethoxy- oder Methoxy-Silane mit einer weiteren funktionalen Amino- oder Epoxy-Gruppe belegt wird.

12. Verfahren nach zumindest einem der vorhergehenden Ansprüche,
**dadurch gekennzeichnet,**
**dass** als Klebemittel ein Klebemittel (30, 26) verwendet wird, dass als Füllstoff zumindest ein Material aus der Gruppe Silber, Kupfer, Nickel, Aluminium, Gold, Graphit, Zink, Zinn, Palladium enthält.

13. Verfahren nach zumindest einem der vorhergehenden Ansprüche,
**dadurch gekennzeichnet,**
**dass** der Bereich der Oberfläche, in dem der Verbinder (18, 20) mit der Solarzelle (10, 100, 140) verbunden wird, mittels eines Klebstoffmaterials geglättet wird, dass auf das Klebstoffmaterial sodann das Klebemittel aufgetragen wird und dass anschließend der Verbinder (18, 20) mit dem Klebemittel elektrisch leitend verbunden wird.

14. Verfahren nach zumindest einem der vorhergehenden Ansprüche,
**dadurch gekennzeichnet,**
**dass** zunächst in dem Bereich der Oberfläche das Lotmaterial eingebracht wird, in dem der Verbinder (18, 20) kontaktiert wird, sodann auf den Bereich das Klebemittel aufgebracht wird und schließlich mit diesem der Verbinder verbunden wird.

## Claims

1. Method for producing an electrically conductive contact on a rear face and/or front face (14, 16) of a solar cell (10, 100, 140), wherein the contact to a connector (18, 20) interconnecting solar cells is connected by means of an adhesive (30, 26),
**characterized in,**
**that** the surface of the rear face and/or front face (14, 16) of the solar cell (10, 100, 140) is treated in the region of the contact to be formed by means of ultrasonic is carried out with at least one action from the following group: partial consolidation, application of soldering.

2. The method of claim 1,
**characterized in,**
**that** as material for the adhesive, one based on at least one material from the group consisting of epoxy resin, phenolic resin, phenoxy resin, polyurethane, silicone, and UV cured acrylate is used, which in particular, is electrically conductive.

3. The method according to claim 1,
**characterized in,**
**that** at least partial compaction of the surface or of a near-surface region is carried out by means of ultrasonication, laser irradiation, thermal treatment and/or mechanical surface treatment.

4. The method according to claim 3,
**characterized in,**
**that** the mechanical surface treatment is carried out by brushing.

5. The method according to at least one of the preceding claims,
**characterized in,**
**that** a material that can be soldered or metallically wetted is alloyed into the surface of the rear face (16) of the solar cell, particularly at least one material from the group of Sn, Pb, In, Ga, Cd, Fe, Ag, Au, Ti, Hf, Zn, Mg , Ca, Ba, soldering material, or a mixture of materials of said group.

6. The method according to at least one of the preceding claims,
**characterized in,**
**that**, as a solar cell, a solar cell (10, 100, 140) that has a porous layer (102) as rear contact over the entire surface of the rear face, in which pad-shaped or strip-shaped regions are formed as the regions with which the adhesive connects, is used.

7. The method according to at least one of the preceding claims,
**characterized in,**
**that**, as a solar cell, a solar cell (10, 100, 140) that has a busbar-free front face with current collectors (fingers) (28) that run roughly parallel to one another is used, to which the adhesive or adhesive tape (30, 26), applied in strips and running crosswise to the current collectors, is connected.

8. The method according to at least one of the preceding claims,
**characterized in,**
**that**, as solar cell (10, 100, 140), a crystalline solar cell, in particular a crystalline silicon solar cell or a thin-layer solar cell, is used.

9. The method according to at least one of the preceding claims,
**Characterized in,**
**that** a connector, which consists, in particular, of soldered copper, zinc-plated copper, or aluminum or soldered aluminum, is connected to the adhesive (30, 26) in an electrically conductive manner.

10. The method according to at least one of the preceding claims,
**characterized in,**
**that** the adhesive is applied onto the region with a width B with 0,5 mm <B <10 mm, in particular 0,8 mm <B <2 mm, and/or a thickness D with 3 µm <D <50 µm.

11. The method according to at least one of the preceding claims,
**characterized in,**
**that** the region coated with the adhesive is coated beforehand with a functional silane from the group consisting of ethoxysilane or methoxysilane with another functional amino group or epoxy group.

12. The method according to at least one of the preceding claims,
**characterized in,**
**that**, as adhesive, an adhesive (30, 26) that contains as filler at least one material from the group consisting of silver, copper, nickel, aluminum, gold, graphite, zinc, tin, and palladium is used.

13. The method according to at least one of the preceding claims,
**characterized in,**
**that** the region of the surface in which the connector (18, 20) is connected to the solar cell (10, 100, 140) is smoothed by means of an adhesive material, that the adhesive is then applied onto the adhesive material and that subsequently the connector (18 , 20) is connected to the adhesive in an electrically conductive manner.

14. The method according to at least one of the preceding claims,
**characterized in,**
**that** the soldering material is initially introduced in the region of the surface in which the connector (18, 20) is contacted, then the adhesive is applied onto the region, and finally the connector is connected to the latter.

## Revendications

1. Procédé de fabrication d'un contact électroconducteur au verso et/ou recto (14, 16) d'une photopile (10, 100, 140), le contact étant relié à un connecteur (18, 20) interconnectant des photopiles au moyen d'un adhésif (30, 26),
**caractérisé en ce**
**que** la surface du recto et/ou verso (14, 16) de la photopile (10, 100, 140) est traitée dans la zone de contact à former par au moins une mesure du groupe compactage au moins partiel, l'application de matériau de soudure se faisant par ultrasons, et que, après le traitement dans cette zone, un adhésif pâteux en forme de bande ou une bande adhésive (30, 26) est appliqué(e)dans la zone en tant qu'adhésif, tout en permettant simultanément une connexion électroconductrice.

2. Procédé selon la revendication 1,
**caractérisé en ce**
**que** le matériau utilisé pour l'adhésif est sur la base d'au moins un matériau du groupe résine époxy, résine phénolique, résine phénoxy, polyuréthane, silicone, un acrylate durcissable aux UV, étant en particulier électroconducteur.

3. Procédé selon au moins la revendication 1,
**caractérisé en ce**
**que** le compactage au moins partiel de la surface ou d'une zone près de la surface se fait par application par ultrasons, irradiation laser, traitement thermique et/ou traitement de surface mécanique.

4. Procédé selon la revendication 3,
**caractérisé en ce**
**que** le traitement de surface mécanique se fait à l'aide d'une brosse.

5. Procédé selon au moins l'une des précédentes revendications,
**caractérisé en ce**
**qu'**un matériau soudable ou mouillable par métal est incorporé par alliage dans la surface du verso (16) de la photopile, en particulier au moins un matériau du groupe Sn, Pb, In, Ga, Cd, Fe, Ag, Au, Ti, Hf, Zn, Mg, Ca, Ba, un matériau de brasage ou un mélange de matériaux du groupe.

6. Procédé selon au moins l'une des précédentes revendications,
**caractérisé en ce**
**que** la photopile utilisée est une photopile (10, 100, 140) présentant sur toute la surface du verso une couche poreuse (102) comme contact arrière, dans laquelle des zones en forme de blocs ou de bandes sont conçues en tant que zones auxquelles l'adhésif est relié.

7. Procédé selon au moins l'une des précédentes revendications,
**caractérisé en ce**
**que** la photopile utilisée est une photopile (10, 100, 140) avec un recto sans barre omnibus avec des collecteurs de courant (doigts) (28) s'étendant approximativement parallèlement les uns aux autres et auxquels est relié(e) l'adhésif apposé en forme de bandes ou la bande adhésive (30, 26), lequel ou laquelle s'étend transversalement aux collecteurs de courant.

8. Procédé selon au moins l'une des précédentes revendications,
**caractérisé en ce**
**que** la photopile (10, 100, 140) utilisée est une photopile cristalline, en particulier une photopile cristalline au silicium, ou une photopile en couches minces.

9. Procédé selon au moins l'une des précédentes revendications,
**caractérisé en ce**
**qu'**un connecteur électroconducteur, constitué en particulier de cuivre brasé, de cuivre galvanisé ou d'aluminium ou d'aluminium brasé, est raccordé à l'adhésif (30, 26).

10. Procédé selon au moins l'une des précédentes revendications,
**caractérisé en ce**
**que** l'adhésif est apposé sur la zone avec une largeur B de 0,5 mm ≤ B <10 mm, en particulier 0,8 mm ≤ B ≤2 mm, et/ou une épaisseur D avec 3 *µ*m ≤ D ≤50 *µ*m.

11. Procédé selon au moins l'une des précédentes revendications,
**caractérisé en ce**
**que** la zone devant être revêtue d'adhésif doit être préalablement revêtue d'un silane fonctionnel du groupe éthoxy- ou méthoxysilane avec un autre groupe fonctionnel amino ou époxy.

12. Procédé selon au moins l'une des précédentes revendications,
**caractérisé en ce**
**que** l'adhésif utilisé est un adhésif (30, 26) contenant en tant que charge au moins un matériau du groupe argent, cuivre, nickel, aluminium, or, graphite, zinc, étain, palladium,

13. Procédé selon au moins l'une des précédentes revendications,
**caractérisé en ce**
**que** la zone de la surface dans laquelle le connecteur (18, 20) est relié à la photopile (10, 100, 140) est lissée au moyen d'un matériau adhésif, que l'adhésif est ensuite apposé sur le matériau adhésif et que finalement le connecteur (18, 20) est raccordé à l'adhésif en étant électroconduteur.

14. Procédé selon au moins l'une des précédentes revendications,
**caractérisé en ce**
**que** le matériau de brasage est tout d'abord introduit dans la zone de la surface dans laquelle le connecteur (18, 20) est en contact, puis l'adhésif est apposé sur la zone et que cette dernière est finalement reliée au collecteur.
